# EUROPEAN PATENT APPLICATION

(11) **EP 1 715 445 A1**
(43) Date of publication of application: **25.10.2006**
(21) Application number: 05709607.5
(22) Date of filing: 02.02.2005
(51) Int. Cl.: G06K 19/00, H05K 3/32, H01L 21/56, H01L 21/60, B42D 15/10, C09J 9/02, C09J 201/00

(54) **ELECTRONIC DEVICE**

(30) Priority: 06.02.2004 JP 2004030535
(71) Applicant: Hitachi Chemical Co., Ltd., Shinjuku-ku, Tokyo 163-0449 (JP)
(72) Inventor: TASAKI, Kouji, Ibaraki 300-4247 (JP); ISHIZAKA, Hironori, Ibaraki 308-8524 (JP); SHIBUTANI, Masahito, Ibaraki 308-8524 (JP); TANAKA, Kousuke, Ibaraki 308-8524 (JP); SHINZAWA, Masahisa, Ibaraki 308-8524 (JP); TONOTSUKA, Hidehiko, Tokyo 101-0062 (JP); IWATA, Katsuya, Tokyo 101-0062 (JP)
(74) Representative: HOFFMANN EITLE
(86) International application number: PCT/JP2005/001486
(87) International publication number: WO 2005/076202

(57) **Abstract**

Disclosed is an electronic device comprising an IC element 10, a first circuit layer 20 on the surface of which is formed an antenna circuit 21 composed of a conductive layer, and a second circuit layer 30 on the surface of which is formed a conductive layer 31. The IC element 10 comprises a base substrate 11 composed of silicon, a semiconductor circuit layer 12 formed on one side of the base substrate 11 in which layer a semiconductor circuit is formed, and an electrode 13 formed on the semiconductor circuit layer 12. The first circuit layer 20 is connected to either the other side of the base substrate 11 or the electrode 13, and the second circuit layer 30 is electrically connected to either that same other side of the base substrate 11 or the electrode 13 which ever is not connected to the first circuit layer 20. Consequently the electronic device can be efficiently produced at low-cost while achieving good communications properties.

## Description

### Technical Field

The present invention relates to an electronic device that can be produced economically and with superior productivity and that provides good communication properties, as a non-contact type individual identification device mounted on an IC element.

### Background Art

In recent years non-contact type individual identification systems that employ RFID (Radio Frequency Identification) tags have been focused on for use in systems for managing the entire lifecycle of a product, including all commercial aspects of production of a product, it's distribution and sales. Radio wave type RFID tags that use 2.45 GHz microwaves are noted for the structure that includes an external antenna attached to IC elements which enables communication to be performed over several meters. Presently, construction is ongoing of systems that operate for distribution of mass-produced products as well as their product management and production history management.

Current examples of radio wave type RFID tag systems using microwaves include products developed by Hitachi Ltd., or Renesas Technology Corp., that use a TCP (Tape Carrier Package) inlet.

Other inlet structures include for example, having an IC element in which the electrodes of an IC element are formed individually on the respective faces of a pair of facing faces, as developed by Usami of Hitachi, having a glass diode package structure in which a dipole antenna connects to each electrode formed on the respective faces (Japanese Unexamined Patent Application Publication No. 2002-269520). Further, in the device disclosed by Usami et al., when the IC element in which the above described two electrodes are formed individually on each of the faces of a pair of facing faces of the IC element is furnished with an excitation slit type dipole antenna, the electrodes formed individually on each of the faces of the pair of facing faces of the IC element are disposed between legs of the antenna to produce a sandwich antenna construction (ISSCC Digest of Technical Papers pages 398-399, 2003). In this dipole antenna structure having an excitation slit, the impedance of the antenna and input impedance of the IC element can be made compatible by changing the width and length of the slit, thereby increasing the distance of achievable transmission.

### Disclosure of the Invention

In order to realize distribution and product management of a large number of products by a non-contact type individual identification system using RFID tags it is necessary to attach an RFID tag to each product, and this makes mass production of RFID tags cheaply indispensable.

However, with an IC element in which two electrodes for signal input and output are formed on the same face, the electrodes on the IC element and the antenna circuits must be positionally aligned very precisely. In order to form a resonant circuit in which the two external electrodes of an IC element are connected to an antenna by spanning an excitation slit in an excitation type dipole antenna construction that provides favorable communication properties however, it is necessary, in the case of an IC element in which all the electrodes are formed on the same face, to achieve precise positioning of the two electrodes for signal input and the slit. Thus, in the conventional art TAB (Tape Automated Bonding) is used, in which IC elements are individually mounted one by one on an antenna substrate, but with this TAB method, the steps involved include suction from the dicing film applied to IC elements having all electrodes formed on the same side thereof using a vacuum suction device, or positionally aligning and thermal compression binding IC elements having all external electrodes formed on the same side with an antenna substrate, and further, sealing with resin is performed for each individual IC element. In these processes, it is extremely troublesome to make the available operating time for each step occur in one second or to reduce this below one second. This is a substantial problem affecting mass production in this method and thus the TAB method has significant problems.

Further, if the available operating time is long then labor expenses increase concomitantly, mitigating against lower-cost production, also as the connection between an IC element having all electrodes formed on the same face thereof and an antenna substrate is realized using a gold-solder connection, it is necessary to use as the substrate material, a taped substrate having copper film attached to polymide film. This is expensive but strongly resistant to heat. This makes it very difficult to produce the inlet economically.

If the above described sandwich antenna construction is used, which encloses by an antenna each of the external electrodes formed individually on each of the faces of an IC element formed having two electrodes one each disposed individually on the respective faces that are a facing pair, it is necessary to form the electrodes on both faces of the IC element and the positioning between an excitation slit and each of the electrodes formed individually on each of the faces of the IC element must be extremely precise. According to the conventional art these electrodes have low electric resistance and are usually made of a metal having superior oxidation resistance properties, which mitigates against realizing low costs.

In light of the above, the object of the present invention is to provide an electrical device that can provide good communication properties, and that can be efficiently produced at low cost.

In order to solve the above described problems, the electronic device related to the present invention is an electronic device including an IC element, and a first circuit layer and a second circuit layer, wherein the IC element further provides a base substrate formed of silicon, a semiconductor circuit layer forming a semiconductor circuit on one side of the base substrate, and an electrode formed on the semiconductor circuit layer, while the first circuit layer is electrically connected either to the other side of the base substrate or the electrode and the second circuit layer is electrically connected to that same other side of the base substrate or the electrode, whichever remains unconnected.

It is preferable that at least one or both of the first and second circuit layers fulfill sending, reception or sending and reception functions.

It is preferable that this electronic device includes an IC element and first and second circuit layers operating as sending and reception antennas, that the IC element further provides a base substrate comprised of silicon, a semiconductor circuit layer forming a semiconductor circuit on one side of the base substrate and an electrode formed over the semiconductor circuit layer, and that either one from among the other side of the base substrate or the electrode, positioned respectively on the respective faces of the pair of facing faces of the IC element is electrically connected to the first circuit layer, while the remaining unconnected side of the base substrate is electrically connected to the second circuit layer.

It is preferable that this electronic device be an electronic device including an IC element, a first circuit layer operating as a transmission and reception antenna forming a slit, and a second circuit layer operating as a bridging plate that electrically connects the IC element and the antenna, in which the IC element further provides a base substrate comprised of silicon, a semiconductor circuit layer forming a semiconductor circuit on one side of the base substrate and an electrode formed on the semiconductor circuit layer, and that either one of the electrode or the other side of the base substrate, these being positioned respectively on the respective faces of the pair of facing faces of the IC element, is electrically connected to the first circuit layer, while the remaining unconnected side of the base substrate is electrically connected to the second circuit layer.

It is preferable that this "other side" of the base substrate be connected with either the first or the second circuit layer via a conductive adhesive agent.

It is preferable that the conductive adhesive agent be comprised of a thermal hardenable matrix resin, and metallic pieces of granular form, scalelike form or acicular form.

It is preferable that at least this other side of the base substrate be connected with either the first or the second circuit layer via an anisotropic conductive adhesive layer.

It is preferable that the anisotropic conductive adhesive layer include a matrix resin and conductive particles comprised of either metallic particles or organic resinous particles having a metallic layer formed on the surface thereof.

It is preferable that the IC element is sealed by a matrix resin of anisotropic conductive adhesive agent.
It is preferable that at least one of either the first or the second circuit layers include a conductive layer of aluminum or copper.

It is preferable that at least one of either the first or the second circuit layers be supported on a base substrate comprised of an organic resin, this organic resin being selectable from polyvinyl chloride (PVC), acrylonitrile butadiene styrene (ABS), polyethylene terephthalate (PET), polyethylene terephthalate glycol (PETG), polyethylene naphthalate (PEN), polycarbonate resin (PC), by axial polyester (O-PET), or polymide resin.

It is preferable that at least one of either the first or the second circuit layers be supported on a base substrate comprised of paper.

The present invention realizes an electrical device that can provide good communication properties, and that can be efficiently produced at low cost.

### BRIEF DESCRIPTION OF THE DRAWINGS

Fig. 1 shows the structure of the inlet according to the present invention viewed from above;
Fig. 2 shows the structure of the inlet of the sandwich antenna configuration according to the present invention viewed from above and showing a cross-sectional view of the structure;
Fig. 3 shows the production process steps relating to a first embodiment of the present invention;
Fig. 4 shows the production process steps relating to a second embodiment of the present invention;
Fig. 5 shows the production process steps relating to a third embodiment of the present invention; and
Fig. 6 shows the production process steps relating to a fourth embodiment of the present invention.

### Best Mode for Carrying out the Invention

The present invention will now be described with reference to the drawings.

The electronic device according to the present invention includes an IC element having an electrode formed on one side thereof while the opposite side is a base substrate comprised of silicon, and first and second circuit layers at least one of which operate as a transmission and reception antenna.

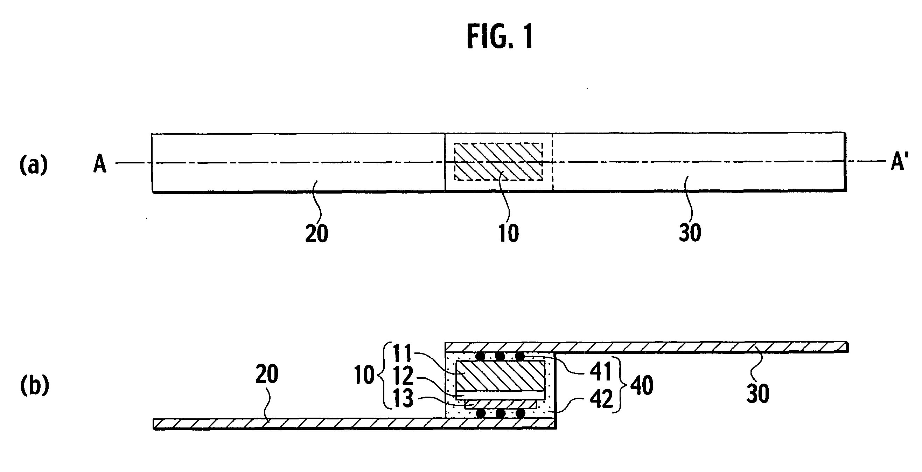

Fig. 1 shows an example of an inlet for an RF ID tag that is the electronic device according to an embodiment of the present invention, providing a schematic view of an inlet in which an IC element is mounted on a dipole antenna. Fig. 1 (a) is a schematic illustration viewed from above while Fig. 1 (b) is a cross-sectional schematic view of the part A-A'. The IC element 10 provides a base substrate 11 comprised of silicon, a semiconductor circuit layer 12 formed on one side of the base substrate 11 and an electrode 13 formed on the semiconductor circuit layer 12. The IC element 10 is connected by the electrode 13 to a first circuit layer 20 that operates as an antenna, via conductive particles 41 included in an anisotropic conductive adhesive layer 40. Further, at the other side of the base substrate 11, the IC element 10 is connected to a second circuit layer 30 that also functions as an antenna, via the conductive particles 41 included in the anisotropic conductive adhesive layer 40. The electrode 13 of the IC element 10 is electrically connected to the first circuit layer 20 while the base substrate 11 is electrically connected to the second circuit layer 30.

Further, the electronic device according to the present invention includes an IC element 10 having an electrode formed on one side thereof while the opposite side is a base substrate 11 comprised of silicon, a first circuit layer 20 in which a slit is formed, this layer operating as a transmission and reception antenna and a second circuit layer 30 that operates as a bridging plate electrically connecting the IC element 10 and the first circuit layer 20.

The structure of the dipole antenna having an excitation slit enables adjustment of the impedance of the antenna and the input impedance of the IC element 10 by adjusting the width and the length of this slit, being a construction suitable for realizing good communication properties.

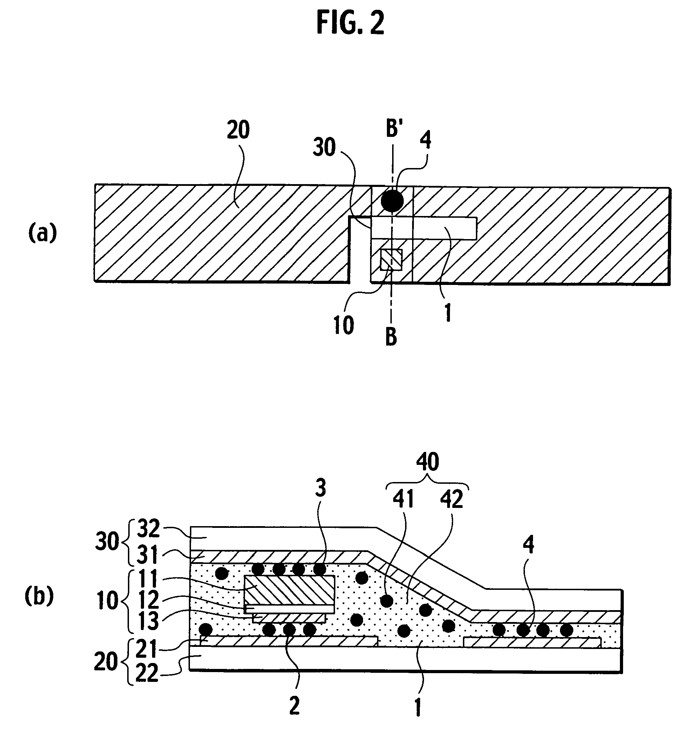

Fig. 2 shows an example of an inlet for an RF ID tag that is the electronic device according to an embodiment of the present invention, showing a sandwich antenna configuration inlet in which an IC element is mounted on an excitation slit type dipole antenna. Fig. 2 (a) is a schematic illustration viewed from above while Fig. 2 (b) is a cross-sectional schematic view of the part B-B'. A simple explanation of this inlet structure will now be provided with reference to Fig. 2.

As applies with respect to the example shown in Fig. 1 (b), here, the IC element 10 has a base substrate (11) comprised of silicon, a semiconductor circuit layer 12 formed over the face of the base substrate 11 and an electrode 13 formed over the semiconductor circuit layer 12. The IC element 10 is connected to a first circuit layer 20 comprised of a base a substrate 22 and an antenna circuit 21 by the electrode 13 in a first connecting part 2 via conductive particles 41 contained in an anisotropic conductive adhesive layer 40. In the same manner, in a second connecting part 3 the base substrate 11 of the IC element 10 is connected to the second circuit layer 30 comprised of a base substrate 32 and conductive layer 31 and the second circuit layer 30 and the first circuit layer 20 are connected in a third connecting part 4, each via the conductive particles 41 included in the anisotropic conductive adhesive layer 40. The second connecting part 3 of the base substrate 11 of the IC element 10 and the third connecting part 4 of the first circuit layer 20 comprise a configuration in which the connection is realized spanning a slit 1 formed in the first circuit layer 20. This is to say, the base substrate 11 and the electrode 13 of the IC element 10 are electrically connected via the first connecting part 2, the antenna circuit 21, the third connecting part 4, and the conductive layer 31 of the second circuit layer 30 and second connecting part 3. Further, the gap between the first circuit layer 20 and the second circuit layer 30 is sealed by the matrix resin 42 of the anisotropic conductive adhesive layer 40. Note that Fig. 2 depicts a configuration in which the base substrate 11 of the IC element 10 is connected to the conductive layer 31 of the second circuit layer 30 and the electrode 13 is connected to the antenna circuit 21, however no change to the performance of the inlet would result were the configuration such that the base substrate 11 of the IC element 10 and the electrode 13 were inverted.

Next, an example will be provided of a method for producing an inlet for an RF ID tag having a sandwich antenna configuration.

The first example of a production method for the electronic device of the present invention has at least a step of forming an antenna circuit using a metallic film; and a step of forming a first circuit layer by disposing the antenna circuit on a base substrate or a step of forming the first circuit layer by providing an antenna circuit from a metallic film disposed on a base substrate; a step of forming a first conductive adhesive layer or an anisotropic conductive adhesive layer on the connecting part of the second circuit layer and the part on the antenna circuit in which an IC element is mounted; a step of positionally arranging and temporarily securing an IC element on the antenna circuit of the first circuit layer; a step of forming an anisotropic conductive adhesive layer or a second conductive adhesive layer on the IC element; a step of positioning the second circuit layer forming a conductive layer such that the second circuit layer is electrically connected in the determined position over the antenna circuit of the first circuit layer and the temporarily secured IC element; and a step of thermal compression binding of the second circuit layer at once via an anisotropic conductive adhesive layer or the second conductive adhesive layer over the first circuit layer and the IC element.

Further, the second example of a production method for the electronic device of the present invention has at least a step of forming an antenna circuit using a metallic film; and a step of forming a first circuit layer by disposing the antenna circuit on a base substrate or a step of forming the first circuit layer by providing an antenna circuit from a metallic film disposed on a base substrate; a step of forming a first conductive adhesive layer or an anisotropic conductive adhesive layer on the part on the antenna circuit of the first circuit layer in which an IC element is mounted; a step of positionally arranging and temporarily securing an IC element on the antenna circuit of the first circuit layer; a step of forming an anisotropic conductive adhesive layer or a second conductive adhesive layer on the IC element; a step of positioning the second circuit layer forming a conductive layer such that the second circuit layer is electrically connected in the determined position over the antenna circuit of the first circuit layer and the temporarily secured IC element; a step of thermal compression binding of the second circuit layer via an anisotropic conductive adhesive layer or the second conductive adhesive layer over the IC element; and a step of compressing the second circuit layer in the determined position of the antenna circuit of the first circuit layer by applying ultrasonic waves.

Further, the third example of a production method for the electronic device of the present invention has at least a step of forming an antenna circuit using a metallic film; and a step of forming a first circuit layer by disposing the antenna circuit on a base substrate or a step of forming the first circuit layer by providing an antenna circuit from a metallic film disposed on a base substrate; a step of forming a first conductive adhesive layer or an anisotropic conductive adhesive layer on the part on the antenna circuit of the first circuit layer in which an IC element is mounted; a step of positionally arranging and temporarily securing an IC element on the antenna circuit of the first circuit layer; a step of forming an anisotropic conductive adhesive layer or a second conductive adhesive layer on the IC element; a step of positioning the second circuit layer forming a conductive layer such that the second circuit layer is electrically connected in the determined position over the antenna circuit of the first circuit layer and the temporarily secured IC element; a step of thermal compression binding of the second circuit layer via an anisotropic conductive adhesive layer or the second conductive adhesive layer over the IC element; and a step of mechanically pressure welding the second circuit layer in the determined position of the antenna circuit of the first circuit layer using a tool having a plurality of acicular protrusions.

In the first to third examples above, the performance of the electronic device is not affected regardless of which from among the electrode of the IC element and the base substrate connects to the first circuit layer and irrespective of the angle of rotation inside the plane of the electrode or bese substrate, thus the present invention is suitable for realizing large-scale production.

In the first to third examples above, at least the connecting parts of the base substrate of the IC element are formed via the conductive adhesive or the anisotropic conductive adhesive layer. The conductive adhesive layer is comprised of a thermal hardenable matrix resin, and metallic pieces of granular form, scalelike form or acicular form. Further, the anisotropic conductive adhesive layer includes a matrix resin and conductive particles comprised of either metallic particles or organic resinous particles having a metallic layer formed on the surface thereof. When the IC element and first and second circuit layers are subject to thermal compression binding the metallic pieces or conductive particles included in the matrix resin are fixed in a dense condition with the silicon comprised base substrate of the IC element, enabling good electrical conductivity to be achieved.

When the connection is performed via an anisotropic conductive adhesive layer the IC element is electrically connected by thermal compression binding with the first and second circuit layers and the gap between the first and second circuit layers can be sealed. Here, it is preferable that the total thickness of the anisotropic conductive adhesive layer be at least half or greater than half the thickness of the IC element as this facilitates sealing with the first and second circuit layers and realizes a high degree of reliability.

In the first to third examples above at least one from among the metallic film forming the antenna circuit of the first circuit layer and the conductive layer forming the second circuit layer must be of aluminum or copper.

In the first to third examples above, at least one from among the first and second metallic layers of the first and second circuit layers is supported by a base substrate comprised either of an organic resin or paper. This organic resin can be selected from polyvinyl chloride (PVC), acrylonitrile butadiene styrene (ABS), polyethylene terephthalate (PET), polyethylene terephthalate glycol (PETG), polyethylene naphthalate (PEN), polycarbonate resin (PC), by axial polyester (O-PET), or polymide resin.

In the first to third examples above the method for forming the first circuit layer involves for example, the method of using metallic film and forming an antenna circuit which is disposed over the base substrate to form the first antenna circuit or the method of disposing metallic film on the base substrate and forming the first circuit layer by forming an antenna circuit on the metallic film by an etching process.

In the first to third examples above the method for disposing a conductive layer for forming the second antenna circuit on the base substrate involves for example, the method of simply adhering metallic film over the base substrate which has a beneficial point of being low cost as there is no necessity to perform a process like etching for example on the metallic film.

In the first to third examples above, when the direction A-A' in Fig. 1 is taken as the widthwise direction it is necessary that the second circuit layer has length sufficient to span the slit to reach the IC element, while having length substantially equivalent to the width of the antenna circuit is preferable for enhancing the overall external appearance of the inlet.

In the first to third examples above, an inlet structure that is the electronic device according to the present invention can be obtained by performing each of the above steps.

An advantageous point about this inlet is that when used in the form of an RFID tag, providing a cover sheet above and below the inlet protects the circuit and prevents short-circuiting.

In the first to third examples above, the connective structure spans a slit using the IC element and second circuit layer therefore it is not necessary to achieve high precision positioning of the excitation slit over the antenna circuit and IC element. This means that even a relative degree of imprecision in the arrangement of a plurality of this IC element achieved using for example a screen or mold will still enable these IC elements to be satisfactorily mounted at once on the first circuit layer. That is to say, in comparison to the case of mounting each of the IC elements individually, superior productivity can be realized. By raising productivity the available operating time required for each inlet can be reduced.

In the first to third examples above, the connective structure is formed spanning a slit using the IC element and second circuit layer, and connections are performed via a conductive adhesive agent or anisotropic conductive adhesive agent layer, thus it is not necessary to form an electrode using gold or the like on the base substrate of the IC element comprised of silicon, thereby realizing lower costs.

In the first to third examples above, the electrical connections of the IC element and first and second circuit layers are performed via a conductive adhesive agent or anisotropic conductive adhesive layer, further, the electrical connections of the first and second circuit layers are connections via a conductive adhesive agent or anisotropic conductive adhesive agent layer, or connections performed by applying ultrasonic waves, or are performed by mechanical pressure welding using a tool having a plurality of acicular protrusions, thus it is not necessary to have a surface coating over the antenna circuit, and there is no necessity to use a highly heat resistant base substrate that can withstand bonding at temperatures of above 200°C in order to form a metallic connection. This makes it possible to use a cheap base material and antenna circuit, thereby enabling cost reductions.

In contrast to the case of the conventional art in which for example it is necessary when making a connection by a gold-tin alloy or the like to use a highly heat resistant polymide as the base material for the first circuit layer base substrate, it is possible to use cheaper polyethylene terephthalate. Further, as it is not necessary to use tin plating on the surface over the antenna circuit at the connecting part, it is possible to use cheaper aluminum that does not form well with a tin or solder coating as the material for the antenna circuit. Accordingly, a first circuit layer made by forming an aluminum antenna circuit on a polyethylene terephthalate base substrate is a satisfactory member for the production of an inlet for an economical RFID tag.

That is to say, the electronic device according to the present invention is an electronic device including an IC element, a first circuit layer having a slit formed therein, this layer operating as a transmission and reception antenna, and a second circuit layer that operates as a bridging plate electrically connecting the IC element and the antenna, wherein the IC element further provides a base substrate formed of silicon, a semiconductor circuit layer forming a semiconductor circuit on one side of the base substrate, and an electrode formed on the semiconductor circuit layer, wherein one from among the electrode (on one side of the base substrate) and the base substrate (the other side of the base substrate not having the electrode) positioned on each of the faces of a pair of facing faces of the IC element, is electrically connected to the first circuit layer and the remaining side of the base substrate is electrically connected to the second circuit layer.

As described with respect to the first to third examples above, as at least the electrical connecting parts of the silicon comprised base substrate of the IC element and the first and second circuit layers are performed via a conductive adhesive agent or anisotropic conductive adhesive agent, therefore the inlet can be produced at low-cost and a remarkable improvement in productivity is realized in the production of the device.

### Embodiments

Exemplary embodiments of the present invention will now be described with reference to the drawings, provided it is understood that the invention is not limited thereby and the following description is illustrative rather than restrictive.

### Embodiment 1

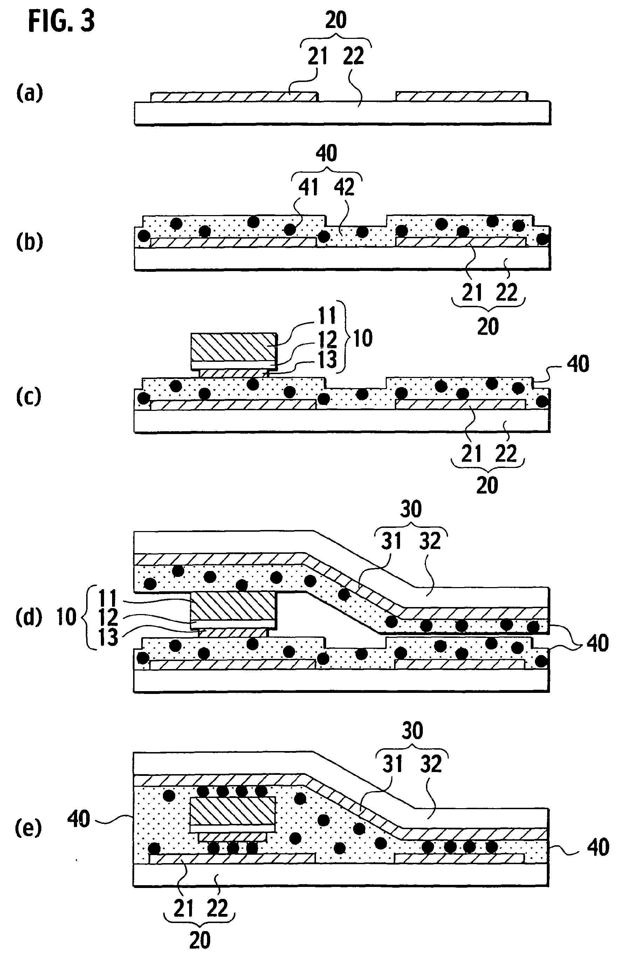

The first embodiment will now be described with reference to Fig. 3.

Firstly, as shown in Fig. 3 (a), an etching resist is formed by screen printing on an aluminum film surface of a tape form substrate produced by adhering aluminum film of a thickness of 9 µm to a polyethylene terephthalate substrate 22 of a thickness of 50 µm using an adhesive agent. Next, an antenna circuit 21 is formed continuously on the aluminum film surface using ferric chloride solution as an etching liquid. Here, the antenna thickness for the antenna circuit 21 is 2.5 mm, the thickness of the slit is 0.5 mm. The drawing includes the following steps, and shows the cross-section of Fig. 2 cut along B-B'.

Next, as shown in Fig. 3 (b), an anisotropic conductive adhesive layer 40 is formed in a determined position over the antenna circuit 21 by lamination at a temperature of 80°C of an anisotropic conductive adhesive film (AC-2052P-45 by Hitachi Chemical, Co., Ltd.), 2 mm wide and 50 m long and then removing the separator film.

Then, as shown in Fig. 3 (c), the IC element 10 is positionally aligned in a determined position over the antenna circuit 21 and temporarily secured. In Fig. 3 (c), the electrode 13 is shown opposing the antenna circuit 21, however it is also suitable for top and bottom to be inverted to have the IC element 10 secured such that the base substrate 11 opposes the antenna circuit 21.

Thereafter, as shown in Fig. 3 (d), on the base substrate 32 of polyethylene terephthalate of a thickness of 50 micrometers and on the aluminum film surface of a tape form substrate 2 mm thick formed by adhering aluminum film of a thickness of 9 micrometers using an adhesive agent, the anisotropic conductive adhesive film 400 of the same width as the tape substrate is laminated at 80°C and the separator film is removed, providing the second circuit layer 30 with anisotropic conductive adhesive layer 40 attached. This is then positionally aligned in a determined position with respect to the first circuit layer 20 and temporarily secured in place with the anisotropic conductive adhesive layer 40 opposing the IC element 10.

Next, as shown in Fig. 3 (e), a press applying head is lowered from the side having the second circuit layer 30 with the anisotropic conductive adhesive layer 40 attached and thermal compression binding at a pressure of 12MPa, at 180°C with the heat being applied for 15 seconds is performed, with the second circuit layer 30 in the determined position with respect to the antenna circuit 21 and the IC element 10 of the first circuit layer 20, while the gaps between the first circuit layer 20 and the second circuit layer 30 are sealed. The press applying head has formed thereon in the required position a protrusion having the same thickness as the IC element 10 such that the connection of the IC element 10 with the first circuit layer 20 and the second circuit layer 30 and the connection of the first circuit layer 20 and the second circuit layer 30 can be performed simultaneously.

The above described steps produce an inlet having the form as that shown in Fig. 2 and Fig. 3 (e). The results of tests conducted to determine the transmission/communications properties of the inlet showed that there were no transmission problems.

Using the above described steps it is not necessary to form an electrode on the silicon comprised 11 (the "other side" as above) of the IC element 10, and an inlet having good communication properties can be realized at low-cost.

### Embodiment 2

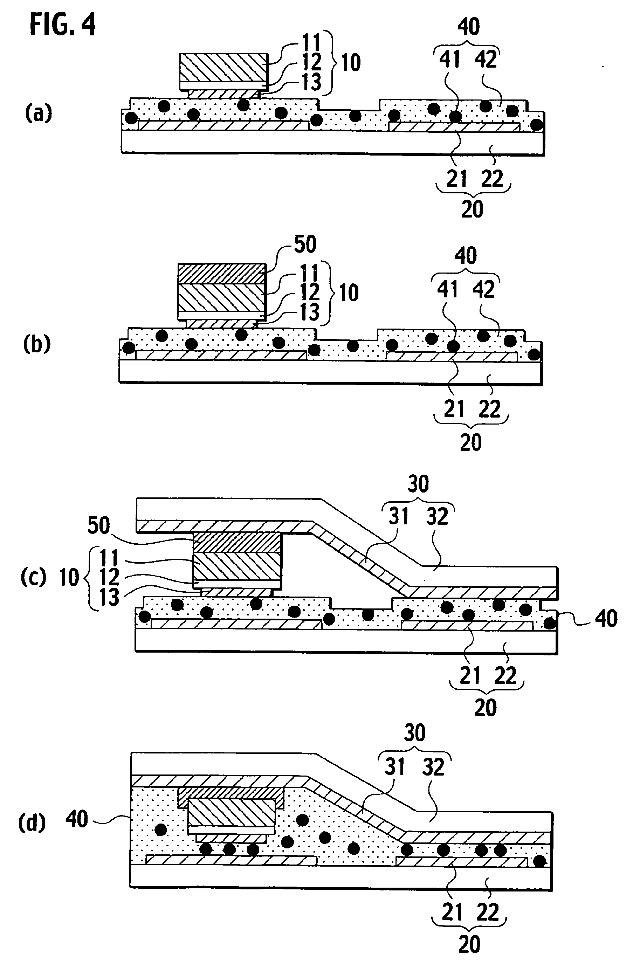

The second embodiment will now be described with reference to Fig. 4.

As shown in Fig. 4 (a) the same processes as applied with respect to the first embodiment are used until the state shown in Fig. 3 (c), i.e. the processes with respect to the first circuit layer 20 are performed, the anisotropic conductive adhesive film is laminated over the antenna circuit to form the anisotropic conductive adhesive layer 40 and the IC element 10 is secured in the determined position on the antenna circuit 21.

Next, as shown in Fig. 4 (b), the face of the IC element 10 opposing the antenna circuit 21 has applied thereon a conductive adhesive agent 50 containing silver filler.

Then, as shown in Fig. 4 (c), aluminum film of a thickness of 9 µm is adhered using an adhesive agent to the base substrate 32 formed of polyethylene terephthalate of a thickness of 50 µm to form a conductive layer 31. The base substrate 32 and conductive layer 31 thus adhered together comprise a tape form second circuit layer 30 of a thickness of 2mm. Next, this second circuit layer 30 is positionally aligned in the determined position with respect to the first circuit layer 20, and temporarily secured in place. At this time the second circuit layer 30 faces in a direction such that the conductive layer 31 with aluminum film is on the side facing the IC element 10.

Next, as shown in Fig. 4 (d) a press applying head is lowered from the second circuit layer 30 side, and thermal compression binding at a pressure of 12MPa, at 180°C with the heat being applied for 15 seconds, is performed with the second circuit layer 30 in the determined position with respect to the antenna circuit 21 and the IC element 10 of the first circuit layer 20, while the gaps between the first circuit layer 20 and the second circuit layer 30 are sealed. The press applying head has formed thereon in the required position a protrusion having the same thickness as the IC element 10 such that the connection of the IC element 10 with the first circuit layer 20 and the second circuit layer 30 and the connection of the first circuit layer 20 and the second circuit layer 30 can be performed simultaneously.

The above described steps produce an inlet having the form as that shown in Fig. 2 and Fig. 4 (d). The results of tests conducted to determine the transmission properties of the inlet showed that there were no transmission problems.

Using the above described steps, in the same manner as applies with respect to the first embodiment, it is not necessary to form an electrode on the silicon comprised 11 (the "other side" as above) of the IC element 10, and an inlet having good communication properties can be realized at low-cost.

### Embodiment 3

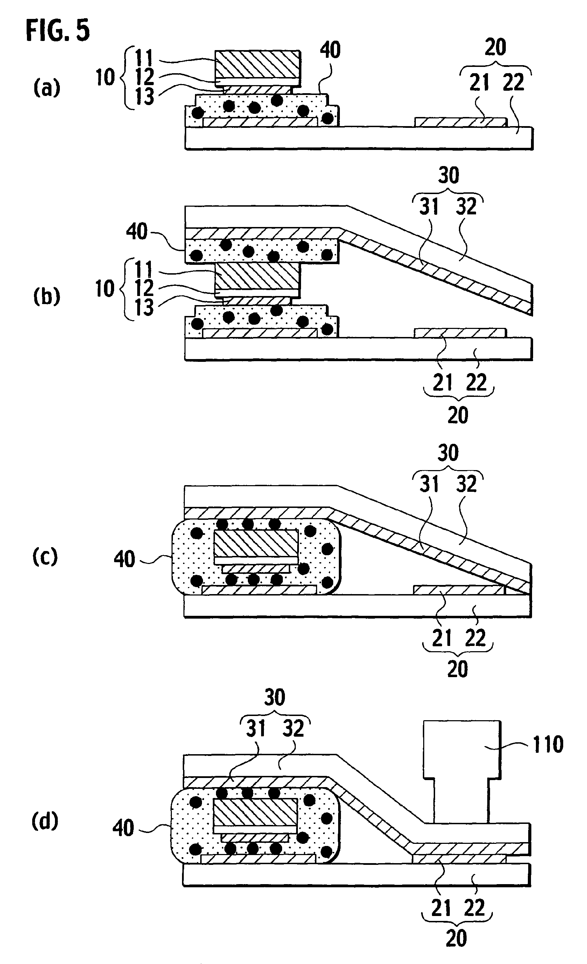

The third embodiment will now be described with reference to Fig. 5.

As shown in Fig. 5 (a) the same processes as applied with respect to the first embodiment are used until the state shown in Fig. 3 (c), i.e. the anisotropic conductive adhesive film is laminated in the determined position in the region of the position in which the IC element 10 is mounted on the antenna circuit 21 forming an anisotropic conductive adhesive layer 40, and the IC element 10 is temporarily secured in the determined position on the antenna circuit 21.

Next, as shown in Fig. 5 (b) the same steps as are applied with respect to Fig. 3 (d) are used, and after the second circuit layer 30 with anisotropic conductive adhesive layer 40 attached is prepared with the anisotropic conductive adhesive layer 40 formed in the determined place in the region of the position of contact with the IC element 10, the anisotropic conductive adhesive layer 40 is matched in the determined position with the first circuit layer 20 in the direction opposing the IC element 10 and temporarily secured.

Next, as shown in Fig. 5 (c), a press applying head is lowered from the second circuit layer 30 side, and thermal compression binding at a pressure of 12MPa, at 180°C with the heat being applied for 15 seconds, is performed at once with the second circuit layer 30 in the determined position with respect to the IC element 10 of the first circuit layer 20, while the region of the IC element 10 between the first circuit layer 20 and the second circuit layer 30 is sealed.

Thereafter, as shown in Fig. 5 (d), in the connecting region of the second circuit layer 30 and the first circuit layer 20 an ultrasonic wave bonding head is lowered from the second circuit layer 30 side and ultrasonic bonding is performed as ultrasonic vibrations of output 1 W are applied for one second, at 180°C at 12 Mpa pressure.

The above described steps produce an inlet having the form as that shown in Fig. 2 and Fig. 5 (d). The results of tests conducted to determine the transmission properties of the inlet showed that there were no transmission problems.

Using the above described steps, in the same manner as applies with respect to the first and second embodiments, it is not necessary to form an electrode on the silicon comprised base substrate 11 (the "other side" as above) of the IC element 10, and an inlet having good communication properties can be realized at low-cost.

### Embodiment 4

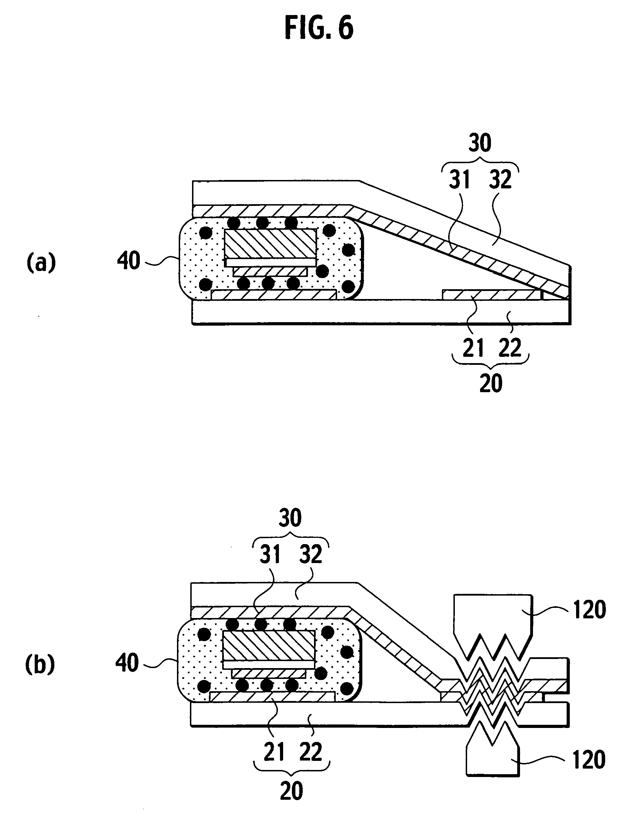

The fourth embodiment will now be described with reference to Fig. 6.

As shown in Fig. 6 (a) the same processes as applied with respect to the third embodiment are used until the state shown in Fig. 5 (c), i.e. the processes for the first circuit layer 20 are performed, the anisotropic conductive adhesive layer 40 is formed, the IC element 10 is temporarily secured in the determined position on the antenna circuit 21, the second circuit layer 30 is prepared with the anisotropic conductive adhesive layer 40 attached and this is then temporarily secured to the first circuit layer 20, and then thermal compression binding with the second circuit layer 30 is performed.

Next, as shown in Fig. 6 (b) the connecting parts of the first circuit layer 20 in the second circuit layer 30 are pressure welded using a pair of caulking tools 120 providing a plurality of acicular, jagged parts. This pressure welding causes a plastic deformation to occur in the aluminum films of the second circuit layer 30 and the first circuit layer 20, such that they are mechanically fixed in a condition of mutual contact, thereby providing an electrical connection. That is to say, the antenna circuit 21 of the first circuit layer 20 and the conductive layer 31 of the second circuit layer 30 are electrically connected.

The above described steps produce an inlet having the form as that shown in Fig. 2 and Fig. 6. The results of tests conducted to determine the transmission properties of the inlet showed that there were no transmission problems.

Using the above described steps, in the same manner as applies with respect to the first to third embodiments, it is not necessary to form an electrode on the silicon comprised 11 (the "other side" as above) of the IC element 10, and an inlet having good communication properties can be realized at low-cost.

The results of the example embodiments are summarized in the following table.

**[Table 1]**

| Embodiment | Communications failures (Failures/Total) | Maximum transmission distance average value (mm) | Maximum transmission distance Maximum value (mm) |
|---|---|---|---|
| Embodiment 1 | 0/40 | 252 | 247 |
| Embodiment 2 | 0/40 | 251 | 245 |
| Embodiment 3 | 0/40 | 251 | 246 |
| Embodiment 4 | 0/40 | 252 | 246 |

## Claims

1. An electronic device comprising an IC element, and a first circuit layer and a second circuit layer,
wherein the IC element further provides a base substrate formed of silicon, a semiconductor circuit layer forming a semiconductor circuit on one side of the base substrate, and an electrode formed on the semiconductor circuit layer,
and wherein the first circuit layer is electrically connected either to the other side of the base substrate or the electrode and the second circuit layer is electrically connected to that same other side of the base substrate or the electrode, whichever remains unconnected.

2. The electronic device according to claim 1 wherein the other side of the base substrate is connected with either the first or the second circuit layer via a conductive adhesive agent.

3. The electronic device according to claim 2 wherein the conductive adhesive agent is comprised of a thermal hardenable matrix resin, and metallic pieces of granular form, scalelike form or acicular form.

4. The electronic device according to claim 1 wherein at least the other side of the base substrate is connected with either the first or the second circuit layer via an anisotropic conductive adhesive layer.

5. The electronic device according to claim 4 wherein the anisotropic conductive adhesive layer includes a matrix resin and conductive particles comprised of either metallic particles or organic resinous particles having a metallic layer formed on the surface thereof.

6. The electronic device according to either of claim 4 or claim 5 wherein the IC element is sealed by a matrix resin of anisotropic conductive adhesive agent.

7. The electronic device according to any of claims 1 to claim 6 wherein at least either the first or the second circuit layers includes a conductive layer of aluminum or copper.

8. The electronic device according to any of claims 1 to claim 7 wherein at least either the first or the second circuit layers is supported on a base substrate comprised of an organic resin, this organic resin being selectable from polyvinyl chloride (PVC), acrylonitrile butadiene styrene (ABS), polyethylene terephthalate (PET), polyethylene terephthalate glycol (PETG), polyethylene naphthalate (PEN), polycarbonate resin (PC), by axial polyester (O-PET), or polyimide resin.

9. The electronic device according to any of claims 1 to claim 7 wherein at least either the first or the second circuit layers is supported on a base substrate comprised of paper.
